# EUROPÄISCHE PATENTSCHRIFT

(11) **EP 2 917 067 B1**
(45) Veröffentlichungstag und Bekanntmachung des Hinweises auf die Patenterteilung: **14.12.2016**
(21) Anmeldenummer: 14700068.1
(22) Anmeldetag: 06.01.2014
(51) Int. Cl.: G01R 19/22, H02H 9/04, B60M 5/02, G01R 19/00

(54) **MESSANORDNUNG UND VERFAHREN FÜR DAS ERKENNEN EINER WECHSELSPANNUNG ALS SCHIENENPOTENTIAL BEI GLEICHSTROMBAHNSYSTEMEN UND ANWENDUNG DER MESSANORDNUNG**
MEASUREMENT ARRANGEMENT AND METHOD FOR DETECTING AN AC VOLTAGE AS A RAIL POTENTIAL IN DC RAILWAY SYSTEMS AND USE OF THE MEASUREMENT ARRANGEMENT
SYSTÈME DE MESURE, PROCÉDÉ DE DÉTECTION D'UNE TENSION ALTERNATIVE SERVANT DE POTENTIEL DE RAIL DANS DES SYSTÈMES FERROVIAIRES À COURANT CONTINU ET UTILISATION DU SYSTÈME DE MESURE

(30) Priorität: 10.01.2013 DE 102013200254
(43) Veröffentlichungstag der Anmeldung: 16.09.2015
(73) Patentinhaber: Siemens Aktiengesellschaft, 80333 München (DE)
(72) Erfinder: BRAUN, Wolfgang, 96191 Viereth-Trunstadt (DE); KUDEREWSKI, Georg, 91301 Forchheim (DE); WOLPENSINGER, Thomas, 91054 Erlangen (DE)
(86) Internationale Anmeldenummer: PCT/EP2014/050073
(87) Internationale Veröffentlichungsnummer: WO 2014/108360

(56) Entgegenhaltungen:
- WO-A1-96/23343
- DE-A1-102008 049 705
- DE-A1-102008 049 706
- DE-A1-102009 043 229

## Beschreibung

Die Erfindung betrifft eine Messanordnung und ein Verfahren für das Erkennen einer Wechselspannung als Schienenpotential bei Gleichstrombahnsystemen sowie eine Anwendung der Messanordnung.

Gemäß der Europäischen Norm EN 50122-1:2010 sind unzulässig hohe Berührungsspannungen an Gleisanlagen, insbesondere unzulässig hohe Schienenpotentiale zwischen Schiene und Erde, zu vermeiden (vgl. EN 50122-1:2010 Kapitel 9 ab Seite 58 ff.). Bei Gleichstrombahnen treten aufgrund der gegen Erde isolierten Schienen während des Bahnbetriebs und insbesondere im Fehlerfall Spannungen zwischen Schienen und Erde auf, die als Berührungsspannung abgegriffen werden können.

Eine Maßnahme zur Verringerung der Gefahren durch Berührungsspannungen ist es, Spannungsbegrenzungseinrichten - auch Voltage Limiting Devices (VLD) genannt - einzusetzen. Eine solche Spannungsbegrenzungseinrichtung besitzt einen hohen Widerstand, wenn die angelegte Spannung niedrig ist und wird leitfähig, wenn ein vorher festgelegter Spannungshöchstwert überschritten wird. Hierdurch kann die unzulässig hohe Spannung abgebaut werden (vgl. EN 50122-1:2010 Anhang F auf Seite 79). Viele Spannungsbegrenzungseinrichten lösen diese Aufgabe dadurch, dass die Potentialdifferenz zwischen Schiene und Erde überwacht wird. Überschreitet sie die in der Norm bzw. vom Betreiber festgelegten Grenzwerte, wird sie dadurch begrenzt, dass Schiene und Erde über eine Schalteinrichtung kurzgeschlossen werden.

Eine Spannungsbegrenzungseinrichtung mit Kurzschließer für Gleichstrombahnanlagen gemäß des Oberbegriffs der Erfindung ist aus der Betriebsanleitung für das Produkt SITRAS SCD Version 3.0.0 der Siemens AG bekannt. Diese Spannungsbegrenzungseinrichtung ist dafür vorgesehen, bei Auftreten unzulässig hoher Berührungsspannungen automatisch die Rückleitung (die Schiene) und die Erde kurzzuschließen; anschließend wird die leitende Verbindung zwischen Schiene und Erde wieder getrennt. Die Schalteinrichtung ist dabei als sogenannte Hybrid-Schalteinrichtung aufgebaut. Sie besteht aus einem Leistungshalbleiter (Thyristor) und einem Leistungsschütz. Der Thyristor ist wirksam bei schnell ansteigenden und hohen Spannungen und das Leistungsschütz (ein steuerbarer Schalter) reagiert bei langsamer ansteigenden und niedrigen Spannungen. Das Schalten des Leistungsschütz wird üblicherweise von einer Steuerung übernommen, welche in einem Zeitraster von 1 ms bis 10 ms die Spannung misst und entsprechend reagiert. Die schnelleren Vorgänge werden von einer diskreten elektronischen Schaltung (Zündelektronik) zur Zündung der Thyristoren gesteuert.

Da das System "isolierte Schiene" traditionell nur Gleichstrombahnen betrifft, wurde in früheren Anlagen nur die Gleichspannung betrachtet. Gemäß der Europäischen Norm EN 50122-3:2010 sind bei der Vermeidung von unzulässig hohen Berührungsspannungen jedoch auch Mischspannungen mit Wechselspannungsanteilen und Gleichstromanteilen zu betrachten. Solche Mischspannungen können beispielsweise auftreten, wenn Gleich- und Wechselspannungsbahnen parallel oder in räumlicher Nähe zueinander liegen. Typisch hierfür sind z. B. die S-Bahn in Berlin und Hamburg, die teilweise auf derselben Trasse fahren wie die Fernbahn aber auch U-Bahnen, welche im Tunnel Fernbahnen kreuzen (Nürnberg Hbf., Nürnberg Rothenburger Straße). Solchenfalls kann z.B. in die elektrischen Anlagen der Gleichstrombahn eine Wechselspannung induziert werden.

Dabei tritt gelegentlich eine so hohe Wechselspannung im Schienenpotential auf, dass diese durch die Zündelektronik erkannt wird und die Thyristoren automatisch gezündet werden. Durch das quasi sofortige Zünden der Thyristoren wird diese Wechselspannung kurzgeschlossen und ist für Steuerung nicht mehr messbar. Entsprechend reagiert diese auch nicht mit einem Schließen des Leistungsschützes. Da der Thyristor bauartbedingt beim Nulldurchgang der Wechselspannung wieder sperrt, entsteht ein sich periodisch wiederholendes Signal mit Spitzenspannung in der Höhe der Auslösespannung der Zündelektronik.

Ist die auftretende unbeeinflusste Wechselspannung deutlich höher als die Auslösespannung der Zündelektronik, entsteht aufgrund der Thyristorzündung eine periodische Wechselspannung mit sehr kurzen Spannungsspitzen in der Höhe der Auslösespannung. Diese sehr kurzen Spannungsspitzen können von einer herkömmlichen Spannungsbegrenzungseinrichtung nicht erkannt werden und somit kein Schließen des Leistungsschützes auslösen. Diese im Schienpotential auftretenden kurzen Spannungsspitzen sind insbesondere problematisch, wenn wie üblich die Höhe der Zündspannung größer als 120 Volt ist und die für solch hohe Berührungsspannungen in der Norm als maximal zulässig definierte Zeitdauer dieser Berührungsspannung überschritten ist.

In der WO 96/23343 A1 ist ein Überspannungsschutzgerät zur Gewährleistung eines Potentialausgleichs bei Überschreiten einer vorgegebenen Spannung zwischen zwei Potentialebenen offenbart.

Es ist die Aufgabe der Erfindung, eine Messanordnung für das Erkennen einer Wechselspannung im Schienenpotential bei Gleichstrombahnsystemen bereit zu stellen.

Diese Aufgabe wird erfindungsgemäß durch eine Messanordnung gemäß dem Anspruch 1 gelöst. Bei der erfindungsgemäßen Messanordnung sorgt das Aufladen der Speichereinrichtung dafür, dass die kurzen, periodisch auftretenden Spannungsspitzen in länger andauernde oder dauernd bestehende Gleichspannungssignale umgewandelt werden. Diese Gleichspannungssignale können von einer im Stand der Technik für Gleichstrombahnsysteme bekannten Auswerteeinrichtung mit einer üblichen Abtastrate von 1 ms (entsprechend 1 kHz) ausgewertet werden, um die Wechselspannung zu erkennen. Eine Auslösung des Leistungsschützes und damit eine nachhaltige Begrenzung der noch anliegenden Spannungsspitzen durch die Steuerung kann erfolgen.

In bisher üblichen Spannungsbegrenzungseinrichtungen gibt es keine Möglichkeit, dieses periodische Signal zu erkennen und durch Schließen des Leistungsschützes nachhaltig abzuschalten. Die bei Gleichstrom angewandte Methode der Strommessung - ein durch die Spannungsbegrenzungseinrichtung fließender Strom gilt bei geöffnetem Leistungsschütz als Indiz für die Zündung der Thyristoren - ist bei Wechselspannung nicht immer gegeben bzw. erst ab einem bestimmten Stromwert möglich. Sollte das Wechselspannungspotential induktiv eingekoppelt sein, reicht dessen Leistung nicht unbedingt aus, um einen mit der üblicherweise vorhandenen Messtechnik messbaren Strom zu erzeugen. Eventuell kann die Zündung der Thyristoren auch bei Wechselspannung über Strommessung erkannt werden. Das Problem dabei ist, dass der Messbereich (Skalenendwert) aufgrund der sehr hohen Stromtragfähigkeit der Spannungsbegrenzungseinrichtung von mehr als 20 kA auch bei der Strommessung relativ groß ist - in der Regel größer als 1000 A. Bei einer üblichen Messgenauigkeit von 1 % lassen sich geringe, induktiv eingekoppelte - Ströme von weniger als 10 A nicht mehr zuverlässig messen.

Es ist daher ein wesentlicher Vorteil der Erfindung, dass eine herkömmliche Steuerung mit einer Abtastrate von 1 ms genutzt werden kann, weil mittels der zusätzlichen einfachen Speichereinrichtung ein detektierbares, relativ lang andauerndes Gleichspannungssignal erzeugt wird. Die Verwendung herkömmlicher Steuerungsbaugruppen für den Leistungsschütz ist besonders kostengünstig und im Stand der Technik lang erprobt. Ein Einsatz von speziellen Steuerungsbaugruppen und aufwendigen Messbaugruppen mit Messraten im µs-Bereich wird vermieden.

In einer bevorzugten Ausführungsform der erfindungsgemäßen Messanordnung weist die Messanordnung einen Trennverstärker auf. Die Verwendung eines Trennverstärkers ist vorteilhaft, weil der Trennverstärker die dem Trennverstärker nachgeordneten Bauteile galvanisch von der Verbindung zwischen Schiene und Erde trennt bzw. entkoppelt. In einer Weiterbildung der vorgenannten Ausführungsform verstärkt der Trennverstärker die Wechselspannung, was das Erkennen der Wechselspannung erleichtert.

In einer anderen bevorzugten Ausführungsform der erfindungsgemäßen Messanordnung weist die Messanordnung eine Überspannungsbeschaltung mit invers-parallelen (gegenläufig ausgerichteten) Dioden oder Varistoren auf. Diese Alternative zur Verwendung eines Trennverstärkers ist vorteilhaft, weil sie besonders kostengünstig ist.

In einer weiteren bevorzugten Ausführungsform der erfindungsgemäßen Messanordnung weist die Gleichrichtungseinrichtung Dioden auf. Diese Ausgestaltung der Gleichrichtungseinrichtung als Diodengleichrichter ist von Vorteil, weil sie weit verbreitet und kostengünstig ist. Insbesondere ist die Verwendung von speziellen Dioden mit sehr niedriger Durchlassspannung, beispielsweise Schottkydioden, vorteilhaft, weil mit solchen speziellen Dioden Wechselspannungsamplituden mit niedrigem Pegel ohne wesentlichen Spannungsabfall gespeichert werden können.

In einer besonders bevorzugten Ausführungsform der erfindungsgemäßen Messanordnung weist die Speichereinrichtung einen Kondensator auf. Ein Kondensator ist besonders gut dafür geeignet, die kurzen, periodisch auftretenden Spannungsspitzen in länger andauernde Spannungssignale umzuwandeln. Dabei sollte die Kapazität des Kondensators so auf die in der Schaltung verwendeten Widerstände abgestimmt sein, dass die Speichereinrichtung im Frequenzbereich der Wechselspannung von Bahnstromanlagen zuverlässig arbeitet. Dieser Frequenzbereich erstreckt sich beispielsweise zwischen 10 Hz und 100 Hz, insbesondere zwischen 16,7 Hz und 60 Hz.

In einer weiteren besonders bevorzugten Ausführungsform der erfindungsgemäßen Messanordnung ist das mindestens eine schaltbare Halbleiterelement ein invers-paralleles Thyristorenpaar. Die Thyristoren werden jeweils leitend geschaltet, sobald an ihrem Gate eine ausreichende Zündspannung anliegt. Diese Zündspannung ergibt sich, wenn an einer mit dem Gate verbundene Diode eine entsprechende Spannung anliegt. Thyristoren werden bei herkömmlichen Messanordnungen in Gleichstrombahnsystem eingesetzt, um Schiene und Erde elektrisch zu trennen und trotzdem einen sicheren Abbau des Schienenpotentials bei Überschreiten der Zündspannung der Thyristoren zu gewährleisten.

In einer anderen bevorzugten Ausführungsform der erfindungsgemäßen Messanordnung ist die Auswerteeinrichtung dafür geeignet, die Amplitude der Wechselspannung zu bestimmen. Dies ist von Vorteil, weil auf diese Weise auch quantitative Informationen über das auf eine Wechselspannung zurückgehende Schienenpotential bestimmt werden können.

Weiterhin ist ein Verfahren gemäß Anspruch 8 Gegenstand der Erfindung. Es ergeben sich für das erfindungsgemäße Verfahren sinngemäß die gleichen Vorteile wie eingangs für die erfindungsgemäße Messanordnung geschildert. Aus den Unteransprüchen 9 bis 14 ergeben sich Ausführungsformen des erfindungsgemäßen Verfahrens mit sinngemäß den gleichen Vorteilen wie für die erfindungsgemäße Messanordnung beschrieben.

Darüber hinaus ist auch die Anwendung der Messordnung nach Anspruch 15 Gegenstand der vorliegenden Erfindung. Es ergeben sich für die erfindungsgemäße Anwendung der Messanordnung sinngemäß die gleichen Vorteile wie eingangs geschildert.

Zur Erläuterung der Erfindung zeigen
- Figur 1: ein Ausführungsbeispiel der erfindungsgemäßen Messanordnung und
- Figur 2: ein anderes Ausführungsbeispiel der erfindungsgemäßen Messanordnung und
- Figur 3: einen Spannungsverlauf einer Wechselspannung, die durch das Zünden der Thyristorenanordnung gemäß Figur 1 periodisch auftretende Spannungsspitzen erzeugt und
- Figur 4: einen Spannungsverlauf, bei dem die periodisch auftretenden Spannungsspitzen aus Figur 3 durch Verwendung der Messanordnung gemäß Figur 1 in eine dauernd bestehende Gleichspannung umgewandelt werden.

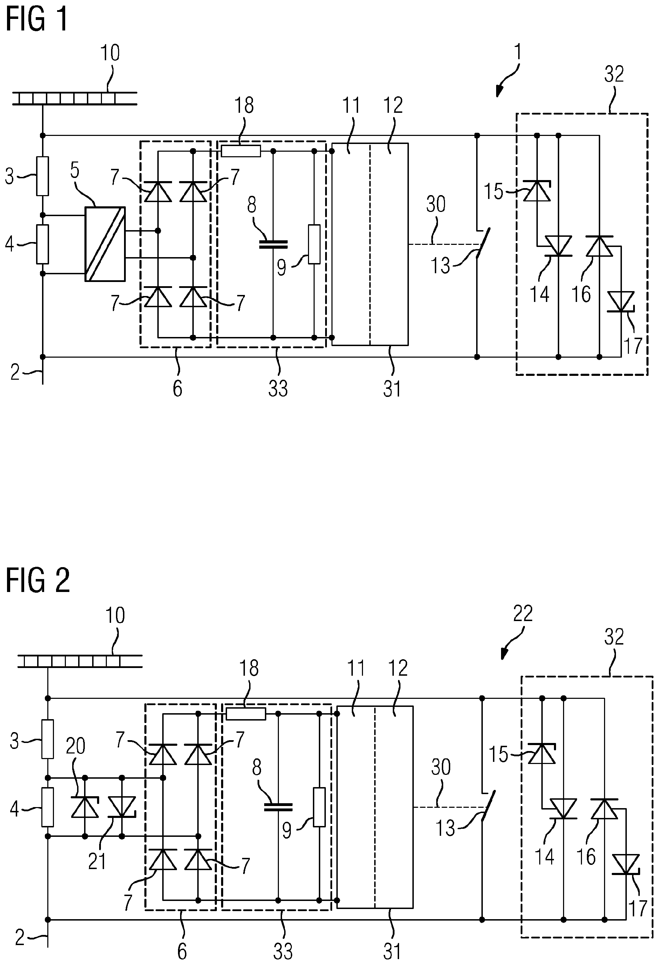

Die Figur 1 zeigt Schienen einer Gleichstrombahn 10, die über mindestens ein schaltbares Halbleiterelement 32 mit dem Erdreich 2 verbunden sind. Das mindestens eine schaltbare Halbleiterelement 32 weist ein invers-paralleles Thyristorenpaar 15,17 und Dioden 14,16 auf. Weiterhin sind Widerstände 3 und 4 parallel zu dem mindestens einen schaltbaren Halbleiterelement 32 angeordnet. Auch ein Leistungsschütz bzw. Schalter 13 ist zu dem mindestens einen schaltbaren Halbleiterelement 32 parallel angeordnet.

Parallel zu dem Widerstand 4 ist ein Trennverstärker zur Entkoppelung der Messanordnung 1 vom Schienenpotential und zur Verstärkung des Eingangssignals der Messelektronik vorgesehen. Dem Trennverstärker 5 ist eine Diodengleichrichterschaltung 6 mit Dioden 7 nachgeschaltet. Die Diodengleichrichterschaltung 6 ist durch ein gestricheltes Kästchen angedeutet.

Der Diodengleichrichterschaltung 6 ist die Speichereinrichtung 33 mit einem ersten Widerstand 18 und einem zweiten Widerstand 9 sowie einem Kondensator 8 nachgeschaltet. Dabei sind der Kondensator 8 und der Widerstand 9 parallel geschaltet. Zur Verwendung in Spannungsbegrenzungseinrichtungen von Gleichstrombahnen sollte die Kapazität des Kondensators so auf die in der Schaltung verwendeten Widerstände angepasst sein, dass die Speichereinrichtung im Frequenzbereich der Wechselspannung von Bahnstromanlagen zuverlässig arbeitet. Dieser Frequenzbereich erstreckt sich beispielsweise zwischen 10 Hz und 100 Hz, insbesondere zwischen 16,7 Hz und 60 Hz. Erreicht wird eine zuverlässige Funktionsweise in dem dargestellten Ausführungsbeispiel mit einem Kondensator 8 mit einer Kapazität von 0,33 µF, einem ersten Widerstand 18 mit 10 Ohm und einem zweiten Widerstand 9 mit 470 kOhm.

Weiterhin schließt sich eine Auswerteeinrichtung 31 an, die eine Eingangselektronik 11 sowie eine Steuerung 12 aufweist. Die Steuerung 12 ist dafür geeignet, über die Verbindung 30 den Schalter 13 zu steuern.

Im Folgenden soll nun kurz die Funktionsweise der in der Figur dargestellten Messanordnung 1 beschrieben werden:
Verlaufen an einer Bahnstromversorgungsanlage Schienen 10 einer Gleichstrombahn in der Nähe oder parallel zu Schienen einer Wechselstrombahn (nicht gezeigt), so kann der Fall auftreten, dass in den Schienen 10 der Gleichstrombahn 10 eine Wechselspannung 34 induziert wird.

Bei einem offenen Schalter 13 fließt zunächst kein Strom zwischen den Schienen 10 und der Erde 2; das Schienenpotential wird nicht abgebaut.

Erst bei Überschreiten einer bestimmten Spannung, der so genannten Zündspannung, wird die Thyristorenanordnung 32, bestehend aus den Thyristoren 17 und 15 und den Dioden 14 und 16 leitend geschaltet. Wenn die Thyristorenanordnung 32 leitend geschaltet ist, wird das Schienenpotential abgebaut und ein Potentialausgleich mit der Erde 2 durchgeführt.

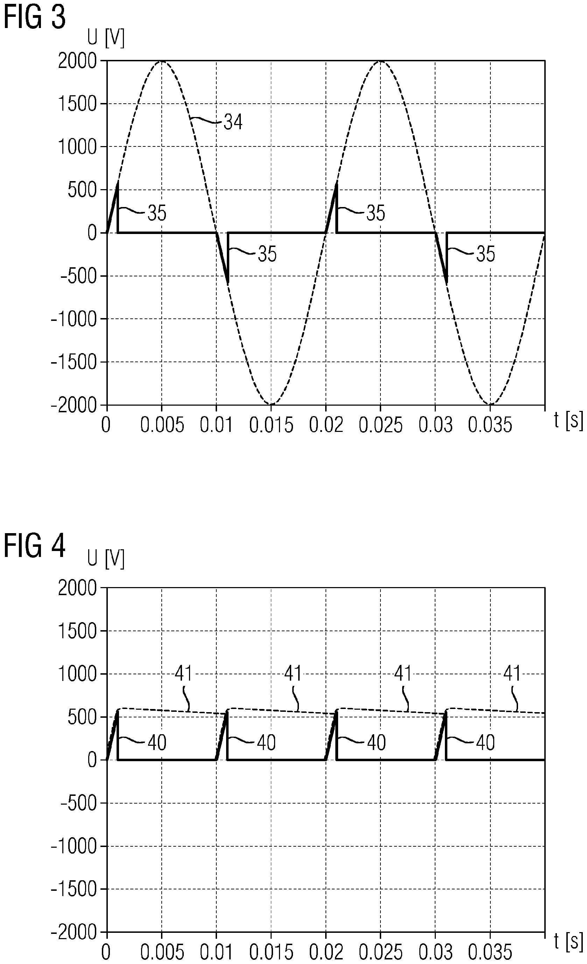

Dabei tritt jedoch das Problem auf, dass die Thyristorenanordnung 32 die Wechselspannung jeweils erst dann ausgleicht, wenn die Zündspannung der Thyristoren 15 und 17 überschritten wird. Hierdurch ergibt sich ein Muster periodisch wiederkehrender Spannungsspitzen in Höhe der Zündspannung der Thyristorenanordnung 32 (vgl. Figur 3), welches zu so kurzen Spannungsspitzen führt, dass diese nicht mittels einer herkömmlichen Steuereinrichtung erkannt werden können und daher auch nicht durch Schließen des Schalters 13 abgebaut werden können. Dies kann insbesondere zu unzulässig hohen Berührungsspannungen an der Schiene 10 führen.

Um solche Wechselspannungsanteile mit Spannungsspitzen zu erkennen, ist die Messanordnung gemäß der Figur 1 vorgesehen. Der Trennverstärker 5 verstärkt die Wechselspannungssignale und bewirkt gleichzeitig eine galvanische Trennung zwischen der Verbindung Schiene 10 und Erde 2 und der Messelektronik, die dem Trennverstärker 5 nachgeschaltet ist. Dies ist notwendig, um beim Auftreten von hohen Spannungen eine Beschädigung der Messelektronik zu verhindern. Das Ausgangssignal des Trennverstärkers 5 wird in dem Diodengleichrichter 6 mit Hilfe der Dioden 7 gleichgerichtet und über den Widerstand 18 auf den Kondensator 8 geladen. Der Kondensator 8 kann das Signal der Spannungsspitzen über den Widerstand 9 auf die Auswerteeinrichtung 31 übertragen, die mit einer Eingangselektronik 11 und einer Steuerung 12 versehen ist. Durch das Speichern der kurzen Spannungsspitzen in dem Kondensator wird eine Verlängerung der Spannungsspitzensignale bewirkt; es ergibt sich länger dauernde oder sogar dauernd bestehende Gleichspannung (vgl. Figur 4), die mittels einer herkömmlichen Messelektronik mit einer Messrate im ms-Bereich in der Auswerteeinrichtung 31 vergleichsweise einfach und günstig erkannt werden kann. Die Steuerung kann dann den Schalter 13 Schließen, um die erkannte Wechselspannung und insbesondere die periodisch auftretenden Spannungsspitzen abzubauen. Auf diese Weise ist sichergestellt, dass auch bei Auftreten von Mischspannungen, d. h. Wechselspannungsanteilen im Schienenpotential einer Gleichstrombahnanlage, keine unzulässig hohen Berührungsspannungen an der Schiene auftreten.

Die Figur 2 zeigt die gleiche Messanordnung wie die Figur 1 - mit dem Unterschied, dass in der Figur 2 die Messanordnung 22 nicht mit einem Trennverstärker 5 ausgestattet ist, sondern stattdessen als Überspannungsschutz für die nachgeschaltete Messelektronik zwei Varistoren oder Zenerdioden 20 und 21 aufweist. Diese Konfiguration ist im Vergleich zur Messanordnung 1 in der Figur 1 deutlich kostengünstiger. Die Messelektronik wird auf diese Weise durch Varistoren oder Zenerdioden 20 und 21 vor zu hohen Spannungen, die oberhalb der Zündspannung der Thyristoren liegen, geschützt.

Die Figur 3 zeigt ein Wechselspannungssignal 34 auf der Spannungsachse U [Volt], das auf der Zeitachse T [Sekunden] gegen die Zeit aufgetragen ist. Das Wechselspannungssignal 34 wird im Schienenpotential einer Gleichstrombahn detektiert. Bei Verwendung einer herkömmlichen Spannungsbegrenzungseinrichtung mit invers-parallelen Thyristoren ergibt sich nun, dass bei Erreichen der Zündspannung der Thyristoren jeweils die Wechselspannung abgebaut wird, da die Spannungsbegrenzungseinrichtung dann Schiene und Erdreich kurzschließt. Hierdurch ergeben sich kurze und periodisch beim Nulldurchgang des Wechselspannungssignals auftretende kurze Spannungsspitzen 35, deren Amplitude der Zündspannung der Thyristorenanordnung entspricht.

In der Figur 4 ist auf den gleichen Achsen U,T ein gleichgerichtetes Wechselspannungssignal 40 zu sehen, das mittels der erfindungsgemäßen Messanordnung detektiert wird. Die Spannungsspitzen 35 aus Figur 3 werden durch die Gleichrichtereinrichtung gleichgerichtet und es ergeben sich die periodisch auftretenden Spannungsspitzen 40. Diese Spannungsspitzen 40 werden in ein länger dauerndes Gleichspannungssignal 41 umgewandelt, welches in der erfindungsgemäßen Messanordnung leicht und sicher zu detektieren ist.

## Patentansprüche

1. Messanordnung (1,22) für ein Schienenpotential bei einem Gleichstrombahnsystem,
- wobei Schienen (10) des Gleichstrombahnsystems durch mindestens ein schaltbares Halbleiterelement (32) mit der Erde (2) verbunden sind,
- wobei das mindestens eine schaltbare Halbleiterelement (32) bei Überschreiten eines Schwellenwertes für das Schienenpotential leitend schaltbar ist und
- wobei die Messanordnung (1,22) in einem parallel zu dem mindestens einen schaltbaren Halbleiterelement verlaufenden Strompfad Schienen (10) und Erde (2) verbindet und eine Auswerteeinrichtung (31) zur Erkennung von Gleichspannungen aufweist,
wobei
- die Messanordnung auch zur Erkennung von Wechselspannungen (34) im Schienenpotential ausgebildet ist, und
- mit einer Gleichrichtungseinrichtung (6)ausgestattet ist, die periodisch auftretende Spannungsspitzen (35) gleichrichtet, wobei die periodisch auftretenden Spannungsspitzen (35) durch das mindestens eine schaltbare Halbleiterelement (32) bei Vorliegen einer Wechselspannung (34) im Schienenpotential erzeugbar sind, und
- mit einer Speichereinrichtung (33) ausgestattet ist, die die gleichgerichteten Spannungsspitzen (40) speichert , **dadurch gekennzeichnet, dass** aus den gleichgerichteten Spannungsspitzen (40) eine zeitlich länger bestehende Gleichspannung (41) von einer von der Auswerteeinrichtung (31) erkennbarer Dauer erzeugt.

2. Messanordnung nach Anspruch 1,
**dadurch gekennzeichnet, dass** die Messanordnung (1,22) einen Trennverstärker (5) aufweist.

3. Messanordnung nach einem der vorhergehenden Ansprüche 1 oder 2,
**dadurch gekennzeichnet, dass** die Messanordnung (1,22) eine Überspannungsbeschaltung (21,22) mit invers-parallelen Dioden oder Varistoren aufweist.

4. Messanordnung nach einem der vorhergehenden Ansprüche 1 bis 3,
**dadurch gekennzeichnet, dass** die Gleichrichtungseinrichtung (6) Dioden (7) aufweist.

5. Messanordnung nach einem der vorhergehenden Ansprüche 1 bis 4,
**dadurch gekennzeichnet, dass** die Speichereinrichtung (33) einen Kondensator (8) aufweist.

6. Messanordnung nach einem der vorhergehenden Ansprüche 1 bis 5,
**dadurch gekennzeichnet, dass** das mindestens eine schaltbare Halbleiterelement (32) ein invers-paralleles Thyristorenpaar (15,17) aufweist.

7. Messanordnung nach einem der vorhergehenden Ansprüche 1 bis 6,
**dadurch gekennzeichnet, dass** die Auswerteeinrichtung (31) dafür geeignet ist, die Amplitude der Wechselspannung (34) zu bestimmen.

8. Verfahren für das Erkennen eines Schienenpotentials bei einem Gleichstrombahnsystem, bei dem Schienen (10) des Gleichstrombahnsystems durch mindestens ein schaltbares Halbleiterelement (32) mit der Erde (2) verbunden sind, und bei dem
- das mindestens eine schaltbare Halbleiterelement (32) bei Überschreiten eines Schwellenwertes für das Schienenpotential leitend schaltet und bei dem
- eine Messanordnung (1,22) in einem parallel zu dem mindestens einen schaltbaren Halbleiterelement verlaufenden Strompfad Schienen (10) und Erde (2) das Schienenpotential misst bei dem
- eine Auswerteeinrichtung (31) Gleichspannungen im Schienenpotential erkennt,
wobei
- eine Gleichrichtungseinrichtung (6) periodisch auftretende Spannungsspitzen (35) gleichrichtet, wobei die periodisch auftretenden Spannungsspitzen (35) durch das mindestens eine schaltbare Halbleiterelement (32) bei Vorliegen einer Wechselspannung (34) im Schienenpotential erzeugt werden, und dass
- eine Speichereinrichtung (33) die gleichgerichteten Spannungsspitzen (40) speichert, **dadurch gekennzeichnet, dass** aus den gleichgerichteten Spannungsspitzen (40) eine zeitlich länger bestehende Gleichspannung (41) von einer von der Auswerteeinrichtung (31) erkennbarer Dauer erzeugt.

9. Verfahren nach Anspruch 8, **dadurch gekennzeichnet, dass** die Wechselspannung (34) zunächst mittels eines Trennverstärkers (5) entkoppelt wird.

10. Verfahren nach einem der vorhergehenden Ansprüche 8 oder 9, **dadurch gekennzeichnet, dass** mittels antiparalleler Dioden oder Varistoren (21,22) ein Überspannungsschutz gewährleistet wird.

11. Verfahren nach einem der vorhergehenden Ansprüche 8 bis 10, **dadurch gekennzeichnet, dass** die Gleichrichtung der periodisch auftretenden Spannungsspitzen (35) mittels Dioden (7) erfolgt.

12. Verfahren nach einem der vorhergehenden Ansprüche 8 bis 11, **dadurch gekennzeichnet, dass** die Speicherung der gleichgerichteten Spannungsspitzen (40) mittels eines Kondensators (8) erfolgt.

13. Verfahren nach einem der vorhergehenden Ansprüche 8 bis 12,
**dadurch gekennzeichnet, dass** das mindestens eine schaltbare Halbleiterelement (32) mittels eines invers-parallelen Thyristorenpaars (15,17) leitend geschaltet wird.

14. Verfahren nach einem der vorhergehenden Ansprüche 8 bis 13,
**dadurch gekennzeichnet, dass** die Amplitude der Wechselspannung (34) bestimmt wird.

15. Anwendung der Messordnung (1) nach einem der vorhergehenden Ansprüche 1 bis 7 zur Erkennung einer Wechselspannung (34), die durch zu den Schienen einer Gleichstrombahn parallel verlaufende Schienen einer Wechselstrombahn in die Schienen der Gleichstrombahn induziert wird.

## Claims

1. Measurement arrangement (1, 22) for a rail potential in a DC railway system,
- wherein rails (10) of the DC railway system are connected to the ground (2) by at least one switchable semiconductor element (32),
- wherein the at least one switchable semiconductor element (32) can be made conductive when a threshold value for the rail potential is exceeded and
- wherein the measurement arrangement (1, 22) connects rails (10) and ground (2) in a current path running parallel to the at least one switchable semiconductor element and has an evaluation device (31) for detecting DC voltages,
wherein
- the measurement arrangement is also designed to detect AC voltages (34) in the rail potential, and
- is fitted with a rectification device (6) which rectifies periodically occurring voltage peaks (35), wherein the periodically occurring voltage peaks (35) can be generated by the at least one switchable semiconductor element (32) when an AC voltage (34) is present in the rail potential, and
- is fitted with a memory device (33) which stores the rectified voltage peaks (40),
**characterised in that**
from the rectified voltage peaks (40) a longer-lasting DC voltage (41) of a duration which can be detected by the evaluation device (31) is generated.

2. Measurement arrangement according to claim 1,
**characterised in that**
the measurement arrangement (1, 22) has an isolation amplifier (5).

3. Measurement arrangement according to one of the preceding claims 1 or 2,
**characterised in that**
the measurement arrangement (1, 22) has a suppressor circuit (21, 22) with inverse-parallel diodes or varistors.

4. Measurement arrangement according to one of the preceding claims 1 to 3,
**characterised in that** the rectification device (6) has diodes (7).

5. Measurement arrangement according to one of the preceding claims 1 to 4,
**characterised in that**
the memory device (33) has a capacitor (8).

6. Measurement arrangement according to one of the preceding claims 1 to 5,
**characterised in that**
the at least one switchable semiconductor element (32) has an inverse-parallel thyristor pair (15, 17).

7. Measurement arrangement according to one of the preceding claims 1 to 6,
**characterised in that**
the evaluation device (31) is suitable for determining the amplitude of the AC voltage (34).

8. Method for detecting a rail potential in a DC railway system, in which rails (10) of the DC railway system are connected to the ground (2) by at least one switchable semiconductor element (32), and in which
- the at least one switchable semiconductor element (32) can be made conductive when a threshold value for the rail potential is exceeded, and in which
- a measurement arrangement (1, 22) measures the rail potential in a current path running parallel to the at least one switchable semiconductor element, in which
- an evaluation device (31) detects DC voltages in the rail potential,
wherein
- a rectification device (6) rectifies periodically occurring voltage peaks (35), wherein the periodically occurring voltage peaks (35) can be generated by the at least one switchable semiconductor element (32) when an AC voltage (34) is present in the rail potential, and in that
- a memory device (33) stores the rectified voltage peaks (40),
**characterised in that**
from the rectified voltage peaks (40) a longer-lasting DC voltage (41) of a duration which can be detected by the evaluation device (31) is generated.

9. Method according to claim 8,
**characterised in that**
the AC voltage (34) is initially decoupled by means of an isolation amplifier (5).

10. Method according to one of the preceding claims 8 or 9,
**characterised in that**
overvoltage protection is ensured by means of antiparallel diodes or varistors (21, 22).

11. Method according to one of the preceding claims 8 to 10,
**c h a r a c t e r i s e d in that**
the rectification of the periodically occurring voltage peaks (35) takes place by means of diodes (7).

12. Method according to one of the preceding claims 8 to 11,
**characterised in that**
the storage of the rectified voltage peaks (40) takes place by means of a capacitor (8).

13. Method according to one of the preceding claims 8 to 12,
**characterised in that**
the at least one switchable semiconductor element (32) is switched to be conductive by means of an inverse-parallel thyristor pair (15, 17).

14. Method according to one of the preceding claims 8 to 13,
**characterised in that**
the amplitude of the AC voltage (34) is determined.

15. Application of the measurement arrangement (1) according to one of the preceding claims 1 to 7 for detecting an AC voltage (34) which is induced in the rails of the DC railway by rails of an AC railway running parallel to the rails of a DC railway.

## Revendications

1. Montage (1,22) de mesure d'un potentiel de rail dans un système de voie à courant continu,
- des rails (10) du système de voie à courant continu étant reliés à la terre (2) par au moins un élément (32) à semiconducteur commutable,
- le au moins un élément (32) à semiconducteur commutable pouvant être mis à l'état passant si une valeur de seuil du potentiel de rail est dépassée et
- le montage (1,22) de mesure reliant des rails (10) et la terre (2) suivant un trajet de courant s'étendant en parallèle au au moins un élément à semiconducteur commutable et ayant un dispositif (31) d'exploitation pour la détection de tension continue,
dans lequel,
- le montage de mesure est constitué aussi pour la détection de tensions (34) alternatives dans le potentiel de rail et
- est équipé d'un dispositif (6) redresseur, qui redresse des pointes (35) de tension se produisant périodiquement, les pointes (35) de tension se produisant périodiquement pouvant être produites par le au moins un élément (32) à semiconducteur commutable, en présence d'une tension (34) alternative dans le potentiel de rail et
- est équipé d'un dispositif (33) accumulateur, qui accumule les pointes (40) de tension redressées,
**caractérisé en ce que**
il est produit, à partir des pointes (40) de tension redressées, une tension (41) continue existant plus longtemps dans le temps, d'une durée pouvant être détectée par le dispositif (31) d'exploitation.

2. Montage de mesure suivant revendication 1,
**caractérisé en ce que** le montage (1,22) de mesure a un amplificateur (5) séparateur.

3. Montage de mesure suivant l'une des revendications précédentes 1 ou 2,
**caractérisé en ce que** le montage (1,22) de mesure a un circuit de surtension ayant des diodes ou des varistances montées tête-bêche.

4. Montage de mesure suivant l'une des revendications précédentes 1 à 3,
**caractérisé en ce que** le dispositif (6) redresseur à des diodes (7).

5. Montage de mesure suivant l'une des revendications précédentes 1 à 4,
**caractérisé en ce que** le dispositif (33) accumulateur a un condensateur (8).

6. Montage de mesure suivant l'une des revendications précédentes 1 à 5,
**caractérisé en ce qu'**au moins un élément (32) à semiconducteur commutable a une paire (15, 17) de thyristors montés tête-bêche.

7. Montage de mesure suivant l'une des revendications précédentes 1 à 6,
**caractérisé en ce que** le dispositif (31) d'exploitation est propre à déterminer l'amplitude de la tension (34) alternative.

8. Procédé de détection d'un potentiel de rail dans un système de voie à courant continu, dans lequel
- des rails (10) du système de voie à courant continu sont reliés à la terre (2) par au moins un élément (32) à semiconducteur commutable,
et dans lequel
- le au moins un élément (32) à semiconducteur commutable peut être mis à l'état passant, si une valeur de seuil du potentiel de rail est dépassée,
et dans lequel
- un montage (1, 22) de mesure mesure le potentiel de rail entre le rail (10) et la terre (2)dans un trajet de courant, s'étendant parallèlement au au moins un élément à semiconducteur commutable, dans lequel
- un dispositif (31) d'exploitation détecte des tensions continues dans le potentiel de rail,
dans lequel
- un dispositif (6) redresseur redresse des pointes (35) de tension, les pointes (35) de tension se produisant périodiquement étant produites par le au moins un élément (32) à semiconducteur commutable, en présence d'une tension (34) alternative dans le potentiel de rail,
et en ce que
- un dispositif (33) accumulateur accumule les pointes (40) de tension redressées,
**caractérisé en ce que**
il est produit à partir des pointes (40) de tension redressées une tension (41) continue existant plus longtemps dans le temps, d'une durée pouvant être détectée par le dispositif (31) d'exploitation.

9. Procédé selon la revendication 8,
**caractérisé en ce que** l'on découple la tension (34) alternative d'abord au moyen d'un amplificateur (5) séparateur.

10. Procédé selon l'une des revendications précédentes 8 ou 9,
**caractérisé en ce que** l'on assure une protection vis-à-vis de la surtension au moyen de diodes ou de varistances (21, 22) montées tête-bêche.

11. Procédé selon l'une des revendications précédentes 8 à 10,
**caractérisé en ce que** le redressement des pointes (35) de tension se produisant périodiquement, s'effectue au moyen de diodes (7).

12. Procédé selon l'une des revendications précédentes 8 à 11,
**caractérisé en ce que** l'accumulation des pointes (40) de tension redressées s'effectue au moyen d'un condensateur (8).

13. Procédé selon l'une des revendications précédentes 8 à 12,
**caractérisé en ce que** le au moins un élément (32) à semiconducteur commutable est monté de manière à être passant au moyen d'une paire (15, 17) de thyristors montés tête-bêche.

14. Procédé selon l'une des revendications précédentes 8 à 13,
**caractérisé en ce que** l'on détermine l'amplitude de la tension (34) alternative.

15. Utilisation du montage (1) de mesure suivant l'une des revendications précédentes 1 à 7 pour la détection d'une tension (34) alternative, qui est induite dans les rails d'un système de voie à courant continu par des rails, s'étendant parallèlement aux rails de la voie à courant continu, d'une voie à courant alternatif.
